# EUROPEAN PATENT APPLICATION

(11) **EP 4 593 236 A1**
(43) Date of publication of application: **30.07.2025**
(21) Application number: 24222046.5
(22) Date of filing: 20.12.2024
(51) Int. Cl.: H02J 7/00, B25F 5/00, G01R 31/382, H01M 10/48, H01M 10/42

(54) **BATTERY FOR A POWER TOOL**

(30) Priority: 19.01.2024 SE 2430015
(71) Applicant: Atlas Copco Industrial Technique AB, 105 23 Stockholm (SE)
(72) Inventor: Sävenlid, Nicholas, 615 33 Valdemarsvik (SE)
(74) Representative: Atlas Copco Industrial Technique AB

(57) **Abstract**

A battery (2) is provided that is arranged to power a power tool (3) connected thereto. The battery comprises a communication interface (6) arranged to communicate with the power tool, and a control device (4). The control device is configured to, via the communication interface, receive from the power tool data indicative of an energy requirement for an upcoming operation to be performed by the power tool; estimate whether the battery at the moment is able to deliver power according to said energy requirement; and, based on the estimation, issue an approval or a denial of taking power from the battery to the power tool for performing the operation.

## Description

### Field of the invention

The present invention generally relates to the field of batteries for power tools.

### Background of the invention

Pneumatic as well as cabled industrial power tools are nowadays often replaced by battery powered tools. Battery powered tools are convenient to use since the lack of a tube/cable greatly improves the mobility of the tool.

A challenge though with battery powered tools is the limit of available energy that the battery can hold in one charge. When the battery is close to running out of charge, the power tool may be able to start an operation but not finish it if the energy available in the battery is not enough for the complete operation. The operator may then have to change battery before starting over the operation to be able to complete it. Another problem is that batteries may get overheated if operations requiring high power are repeated with only short pauses in between. An operation may then automatically be prematurely interrupted as the temperature of the battery exceeds its' maximum limit. The operator may then have to wait for the battery to cool down and then starting over the operation to be able to complete it. In industrial manufacturing/assembly where the demand on productivity is high, this extra time cost for re-starting operations is disadvantageous. Further, in some cases, the operator may mistakenly believe that an interrupted operation has ended as normal (because the operation program was completed) when it in fact was ended due to lack of battery power and/or due to overheating of the battery. This may have vast consequences on the quality of the production.

Many power tools have indicators for indicating the level of charge of the battery so the operator can replace the battery when the indicator level is low. However, this may be missed by an operator who may anyway start an operation without noticing the need of charge, which may result in the operation getting interrupted as the battery runs out of charge. Further, the level of charge that triggers low level indication may typically be set with some margin, whereby the battery may get replaced still having some available energy left that in theory could be used for further operations. Hence, this could lead to more frequent battery replacements (which are time consuming) than necessary.

Hence, there is a need for improvements in the field.

### Summary of the invention

It would be advantageous to achieve a battery overcoming, or at least alleviating, the above mentioned drawbacks. In particular, it would be desirable to enable a battery allowing an increased productivity and improved quality in industrial manufacturing/assembly.

To better address one or more of these concerns, a battery having the features defined in the independent claim is provided. Preferable embodiments are defined in the dependent claims.

Hence, according to an aspect, a battery arranged to power a power tool connected thereto is provided. The battery comprises a communication interface arranged to communicate with the power tool and a control device.

The control device is configured to:
- via the communication interface, receive from the power tool data indicative of an energy requirement for an upcoming operation to be performed by the power tool;
- estimate whether the battery at the moment is able to deliver power according to said energy requirement; and
- based on the estimation, issue an approval or a denial of taking power from the battery to the power tool for performing the operation.

Traditional power tool batteries typically per default let the power tool simply draw current from the battery when an operation is performed. With the present invention, the power tool communicates its' energy demands/requirements for the upcoming operation to the battery before starting the operation so the battery can assess whether it is able to deliver the energy as required for the upcoming operation. The battery may then issue an approval or denial of taking power from the battery for performing the operation.

The control device may be configured to issue the approval in response to estimating that the battery at the moment is able to deliver power according to the energy requirement and to issue the denial in response to estimating that the battery at the moment is unable to deliver power according to the energy requirement.

For example, the battery may communicate the approval or denial to the power tool (via the communication interface). The tool may, in response to an approval, start the operation and draw current from the battery and in response to a denial refrain from starting an operation and thereby refrain from drawing current from the tool. Alternatively, the control device may itself enable/disable delivery of power to the tool in response to the approval or denial.

Hence, the operation may only be started if it is determined/estimated that the battery can actually deliver power as required for the operation. In case the battery estimates that it, for some reason, will not be able to deliver according to the energy requirement, start of an operation that potentially would not be possible to finish, can be avoided. Instead, the operator may directly e.g. change battery or wait for the battery to cool down before starting the intended operation. This reduces downtime in the production. Further, the reduced risk of unintendedly prematurely interrupted operations improves the quality of the production.

Approving or denying taking power from the battery for the upcoming operation may also be expressed as approving or denying start of the upcoming operation.

According to an embodiment, the energy requirement for the upcoming operation may comprise an estimated amount of energy required for the upcoming operation (such as in terms of Ws or joule). By checking whether the battery can deliver the estimated amount of energy for the upcoming operation as indicated by the tool, and only approve taking power from the battery if it can, reduce the risk of starting an operation when the battery holds less energy than that required for the operation. Thus, the operation being interrupted as a consequence of the battery running out of charge is reduced.

According to an embodiment, estimating whether the battery at the moment is able to deliver power according to the energy requirement may comprise to:
- estimate an amount of energy currently available in the battery for powering the power tool, and
- determine whether the estimated amount of available energy is greater than the amount of energy as indicated by the data received from the power tool.

The estimation of the amount of energy currently available in the battery may e.g. be based on a measured voltage of the battery and/or may be performed by deducting the energy delivered for each operation from the amount of energy available at full charge of the battery.

According to an embodiment, the energy requirement for the upcoming operation may comprises a profile indicative of an energy consumption over time for the upcoming operation.

Such a profile may give an indication of how high power will be needed and for how long time. This may be necessary information in order to estimate if the battery risks getting overheated during the operation.

For example, the energy consumption/time profile may be a more or less detailed curve or just a rough specification in steps, such as e.g. 20A for 100s, 50A for 5s, 80A in 1s and 100A for 0,1s. The energy consumption may e.g. be expressed as power (W), current (A) or any other parameter indicative of the energy consumption of the tool (per time unit).

Optionally, the profile, if expressed as a curve, may be integrated (by the control device of the battery or by a control device of the tool) in order to estimate the amount of energy needed for the operation. In other words, the area under the curve corresponds to the amount of energy required. Hence, the profile can also be used for estimating the amount of energy needed to complete the operation.

According to an embodiment, the battery may further comprise a temperature sensor arranged to sense the temperature of one or more cells of the battery, wherein estimating whether the battery at the moment is able to deliver power according to the energy requirement may be based on a current temperature as indicated by data received from the temperature sensor.

Temperature data may be used as a basis for estimating whether the battery risk getting overheated during the upcoming operation. The higher the temperature of the cell(s) is, the less operating power is needed to push the temperature over the allowable limit.

The temperature sensor may be located on, or at least in the vicinity of, the one or more cells.

By "current temperature" it is meant a temperature registered by the sensor within the last few seconds or so.

According to an embodiment, estimating whether the battery at the moment is able to deliver power according to the energy requirement may comprise to:
- based on the current temperature, the energy requirement and a thermal model, estimate a maximum temperature of the one or more cells, that will occur as a result of the operation. Further, issuing the approval or denial may be based on whether the estimated maximum temperature is below or above a predetermined threshold.

With the present embodiment, a more accurate temperature-based estimation is provided, which will improve the accuracy in the approval/denial decision.

The thermal model may define a relationship between power output from the battery over time and an estimated resulting temperature in the one or more cells. The thermal model may be expressed as a function or as a look up table.

The predetermined threshold may indicate a temperature which preferably should not be exceeded for avoiding damage of the battery due to overheating.

According to an embodiment, the control device may be further configured to:
- in response to the maximum temperature being above the predetermined threshold, estimate a time period that has to lapse before starting the operation; and
- issue a notification indicating the time period.

Awaiting the time period before starting the operation will allow the battery to cool down sufficiently to be able to perform the upcoming operation without (or at least with reduced risk of) causing overheating of the one or more cells. With the present embodiment, the user will, instead of having to guess, get a qualified estimation of how long he/she will have to wait before starting the operation. This will improve the efficiency of the production process.

The notification may be communicated to the power tool via the communication interface. The notification may be displayed to a user, either on a display on the power tool itself or on an external display.

According to an embodiment, the control device may be further configured to, in case issuing a denial, issue a notification indicative thereof. Thereby, the user will be able to take an appropriate action, such as replacing the battery with a charged one or waiting for the battery to cool down.

The notification may be communicated to the power tool via the communication interface. The notification may be displayed to a user, either on a display on the power tool itself or on an external display.

The notification may e.g. indicate that there is not enough energy available in the battery at the moment. The notification may be the same as the notification indicating the time period necessary to wait until starting an operation. According to an embodiment, a kit is provided. The kit may comprise a power tool and a battery according to any one of the preceding embodiments for powering the power tool.

The power tool may further comprise a communication interface arranged to be connected (wirelessly or by wire) to the communication interface of the battery to enable communication of data therebetween.

According to an embodiment, the power tool may comprise a control device configured to determine the energy requirement for the upcoming operation and to communicate that to the control device of the battery (via the communication interface of the battery).

According to an embodiment, the control device of the power tool may be configured to communicate the energy requirement to the battery in response to a user triggering start of an operation of the power tool. Hence, the estimation of whether the battery will be able to deliver power according to the energy requirement will be done as a check just before the operation starts.

It is noted that embodiments of the invention relate to all possible combinations of features recited in the claims.

### Brief description of the drawings

This and other aspects will now be described in more detail in the following illustrative and non-limiting detailed description of embodiments, with reference to the appended drawing.
Figure 1 illustrates a kit comprising a power tool and a battery according to an embodiment.
Figure 2 illustrates a profile indicating an estimated energy consumption for an upcoming operation.

All the figures are schematic, not necessarily to scale, and generally only show parts which are necessary in order to elucidate the embodiments, wherein other parts may be omitted. Like reference numerals refer to like elements throughout the description.

### Detailed description of embodiments

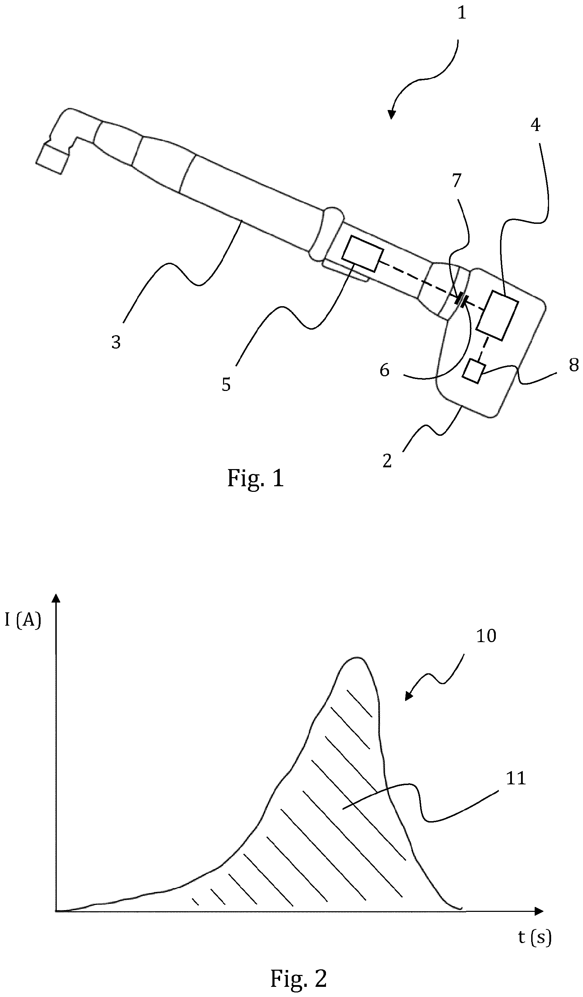

A kit 1 comprising a power tool 3 and a battery 2 according to an embodiment will be described with reference to Figure 1. The power tool 3 may e.g. be a tightening tool (as illustrated), a riveting tool, a drill or any other kind of power tool. The power tool 3 may be arranged to perform operations (such as tightening operations) in an industrial production process.

The battery 2 is arranged to be connected to the power tool 3 for powering operation of the power tool 3. The battery 2 comprises a control device 4 and a communication interface 6 for communicating with the power tool 3. The communication interface 6 may e.g. be a contact for wired communication or an antenna for wireless communication. The communication interface 6 may be arranged to mate with a corresponding communication interface 7 of the power tool 3.

The power tool 3 may also comprise a control device 5. The control device 5 of the power tool 3 may be arranged to communicate via the communication interfaces 7, 6 with the control device 4 of the battery 2.

The control devices 4, 5 may each one comprise processing circuitry and a memory for storing data and instructions to be executed by the processing circuitry.

The battery 2 may further comprise a temperature sensor 8 arranged to sense the temperature of the one or more cells of the battery 2. The temperature sensor 8 may be connected to the control device 4 of the battery 2 to communicate temperature data.

When the power tool 3 is about to perform an operation, the control device 4 of the battery 2 receives data from the power tool 3, such as upon an operator triggering start of an operation, e.g. by pushing a trigger actuator. The data comprise an energy requirement for the upcoming operation (triggered by the operator).

The energy requirement may e.g. comprise an estimated amount of energy required for the operation. Alternatively, or as a complement, the energy requirement may comprise a profile 10 indicating an estimated energy consumption over time for the upcoming operation. As illustrated in Figure 2, the profile 10 may e.g. be a curve/function representing the energy consumption, e.g. expressed as a current consumption, throughout the operation. Alternatively, the profile may be less complex, simply stating expected energy consumption in rough time steps, such as 20A for 100s, 50A for 5s, 80A in 1s and 100A for 0,1s.

From this profile 10, the control device 4 of the battery 2 may derive information about the upcoming operation. For example, the control device 4 may derive an estimated total amount of energy to be consumed by the tool 3 during the upcoming operation from the profile 10. This may e.g. be derived from the area 11 under the curve 10, e.g. by means of integration.

As a further example, from the level of energy consumption vs time, the control device 4 may be able to estimate a temperature rise of the battery 2 during the upcoming operation. The higher current drawn by the tool 2, the faster/higher the temperature will rise. For example, the control device 4 may use a thermal model together with a current temperature as detected by the temperature sensor 8 to estimate how much the temperature will rise during the tightening. For example, the control device 4 may estimate a maximum temperature that will be reached as a result of the operation. The control device 4 may then compare this maximum temperature with a predetermined temperature threshold defining a maximum allowable temperature of the battery 2. A temperature exceeding that threshold may harm/damage the battery 2.

The control device 4 of the battery 2 may be further configured to determine whether the battery 2 is able to deliver power to the tool 3 according to the by the tool 3 communicated energy requirements of the upcoming operation. For example, the control device 4 of the battery 2 may estimate its' current energy level to see if this is enough to deliver the required amount of energy. Further, as an alternative, or as a complement, the control device 4 may check whether the expected temperature rise (starting from the detected current temperature and e.g. calculated as explained above) is within allowable limits.

If the control device 4 of the battery 2 estimates that it will be able to deliver power according to the energy requirements as indicated by the tool 3, the control device 4 may issue an approval to take power from the battery 2 for the operation. If not, the control device 4 may instead issue a denial to take power from the battery 2. The approval/denial may e.g. be communicated to the tool 3, which may act accordingly by starting/disable starting the operation and optionally notify the operator accordingly. Alternatively, the battery 2 may itself enable/disable delivery of power in response to the issued approval/denial.

In case the control device 4 estimates the temperature to exceed the maximum allowable temperature during/just after the operation, the control device 4 may estimate a time period that has to lapse for the battery 2 to cool down sufficiently to be able to perform the operation. The time period may be sent as a notification to the user via the power tool 3 or via an external device.

The person skilled in the art realizes that the present invention by no means is limited to the embodiments described above. On the contrary, many modifications and variations are possible within the scope of the appended claims.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage.

## Claims

1. Battery (2) arranged to power a power tool (3) connected thereto, the battery comprising:
a communication interface (6) arranged to communicate with the power tool; and
a control device (4) configured to:
- via the communication interface, receive from the power tool data indicative of an energy requirement for an upcoming operation to be performed by the power tool;
- estimate whether the battery at the moment is able to deliver power according to said energy requirement; and
- based on the estimation, issue an approval or a denial of taking power from the battery to the power tool for performing the operation.

2. Battery as defined in claim 1, wherein said energy requirement for the upcoming operation comprises an estimated amount of energy required for the upcoming operation.

3. Battery as defined in claim 2, wherein estimating whether the battery at the moment is able to deliver power according to said energy requirement comprises to:
- estimate an amount of energy currently available in the battery for powering the power tool, and
- determine whether the estimated amount of available energy is greater than the amount of energy as indicated by the data received from the power tool.

4. Battery as defined in any one of the preceding claims, wherein said energy requirement for the upcoming operation comprises a profile (10) indicative of an energy consumption over time for the upcoming operation.

5. Battery as defined in any one of the preceding claims, further comprising a temperature sensor (8) arranged to sense the temperature of one or more cells of the battery,
wherein estimating whether the battery at the moment is able to deliver power according to said energy requirement is based on a current temperature as indicated by data received from the temperature sensor.

6. Battery as defined in claim 5, wherein estimating whether the battery at the moment is able to deliver power according to said energy requirement comprises to:
- based on said current temperature, the energy requirement and a thermal model, estimate a maximum temperature of the one or more cells, that will occur as a result of the operation,
wherein issuing said approval or denial is based on whether said maximum temperature is below or above a predetermined threshold.

7. Battery as defined in claim 6, the control device being further configured to:
- in response to said maximum temperature being above the predetermined threshold, estimate a time period that has to lapse before starting the operation; and
- issue a notification indicating said time period.

8. Battery as defined in any one of the preceding claims, the control device being further configured to, in case issuing a denial, issue a notification indicative thereof.

9. Kit (1) comprising a power tool (3) and a battery (2) according to any one of the preceding claims for powering the power tool.

10. Kit according to claim 9, wherein the power tool comprises a control device (5) configured to determine said energy requirement for the upcoming operation and to communicate that to the control device of the battery.

11. Kit according to claim 10, the control device of the power tool being configured to communicate said energy requirement to the battery in response to a user triggering start of an operation of the power tool.
